(19) **Europäisches Patentamt / European Patent Office / Office européen des brevets**

(11) **EP 1 005 733 B1**

(12) **EUROPÄISCHE PATENTSCHRIFT**

(45) Veröffentlichungstag und Bekanntmachung des Hinweises auf die Patenterteilung:
**29.10.2008 Patentblatt 2008/44**

(21) Anmeldenummer: **98945067.1**

(22) Anmeldetag: **29.07.1998**

(51) Int Cl.:
**H04L 1/18** (2006.01)

(86) Internationale Anmeldenummer:
**PCT/DE1998/002165**

(87) Internationale Veröffentlichungsnummer:
**WO 1999/011010 (04.03.1999 Gazette 1999/09)**

(54) **VERFAHREN ZUR PAKETÜBERTRAGUNG MIT EINEM ARQ-PROTOKOLL AUF ÜBERTRAGUNGSKANÄLEN IN EINEM DIGITALEN ÜBERTRAGUNGSSYSTEM**

METHOD FOR PACKET TRANSMISSION WITH AN ARQ PROTOCOL ON TRANSMISSION CHANNELS IN A DIGITAL TRANSMISSION SYSTEM

PROCEDE POUR LA TRANSMISSION PAR PAQUETS AVEC UN PROTOCOLE ARQ SUR DES CANAUX DE TRANSMISSION DANS UN SYSTEME DE TRANSMISSION NUMERIQUE

(84) Benannte Vertragsstaaten:
**DE FI FR GB SE**

(30) Priorität: **22.08.1997 DE 19736676**

(43) Veröffentlichungstag der Anmeldung:
**07.06.2000 Patentblatt 2000/23**

(73) Patentinhaber: **SIEMENS AKTIENGESELLSCHAFT 80333 München (DE)**

(72) Erfinder:
- **DOETSCH, Markus**
  **D-56072 Koblenz (DE)**
- **PLECHINGER, Jörg**
  **D-80469 München (DE)**
- **JUNG, Peter**
  **D-67697 Otterberg (DE)**
- **BERENS, Friedbert**
  **D-67663 Kaiserslautern (DE)**

(56) Entgegenhaltungen:
**WO-A-98/05140          WO-A-98/43383**

- **NARAYANAN K R ET AL: "A NOVEL ARQ TECHNIQUE USING THE TURBO CODING PRINCIPLE" IEEE COMMUNICATIONS LETTERS, Bd. 1, Nr. 2, März 1997, Seiten 49-51, XP000687091**
- **NASSHAN M ET AL: "New results on the application of antenna diversity and turbo-codes in a JD-CDMA mobile radio system" 5TH IEEE INTERNATIONAL SYMPOSIUM ON PERSONAL, INDOOR AND MOBILE RADIO COMMUNICATIONS (PIMRC'94), AND ICCC REGIONAL MEETING ON WIRELESS COMPUTER NETWORKS (WCN), THE HAGUE, THE NETHERLANDS, Bd. 2, 18. - 23. September 1994, Seiten 524-528, XP002091099 Amsterdam, IOS Press, Netherlands**
- **JUNG P: "COMPARISON OF TURBO-CODE DECODERS APPLIED TO SHORT FRAME TRANSMISSION SYSTEMS" IEEE JOURNAL ON SELECTED AREAS IN COMMUNICATIONS, Bd. 14, Nr. 3, 1. April 1996, Seiten 530-537, XP000586080 in der Anmeldung erwähnt**
- **NARAYANAN K R ET AL: "PHYSICAL LAYER DESIGN FOR PACKET DATA OVER IS-136" 1997 IEEE 47TH. VEHICULAR TECHNOLOGY CONFERENCE, PHOENIX, AZ, USA, Bd. 2, Nr. 47, 4. - 7. Mai 1997, Seiten 1029-1033, XP000736764 INSTITUTE OF ELECTRICAL AND ELECTRONICS ENGINEERS**

**Beschreibung**

Die Erfindung betrifft ein Verfahren zur Paketübertragung mit einem ARQ-Protokoll auf Übertragungskanälen in einem digitalen Übertragungssystem, bei dem zur Kanalcodierung senderseitig in einem Turbo-Codierer eine Turbo-Codierung und empfängerseitig in einem Turbo-Decodierer eine Turbo-Decodierung mit Soft-Decision-Ausgangssignalen durchgeführt wird, wobei ein Rückkanal vorgesehen ist, mit dem der Empfänger die Information von fehlerhaften Paketen erneut anfordert.

In P. Jung, "Comparison of Turbo-Code Decoders Applied to Short Frame Transmission Systems", IEEE Journal on Selected Areas in Communications, Band 14 (1996) Seiten 530 - 537 wird die Anwendung von Turbo-Codes für digitale Übertragungssysteme untersucht, wobei sowohl Codierer als auch Decodierer für die Turbocodes in der Übertragungsstrecke untersucht werden. Die Decodierung der Turbocodes beruht auf der Verwendung von Soft-Input/Soft-Output-Decodierern, die entweder unter Verwendung von MAP(Maximum a-posteriori)-Symbolschätzern oder von MAP-Sequenzschätzern, beispielsweise einem Schätzer mit einem a-priori-Soft-Output-Viterbi-Algorithmus (APRI-SOVA) verwirklicht werden können. In dieser Veröffentlichung werden vier verschiedene Decodiereranordnungen und ihre Fähigkeiten, bestimmte Fehlerraten zu verarbeiten, beschrieben. Außerdem wird die Leistungsfähigkeit dieser Decoder bei verschiedenen Anwendungsfällen untersucht. Es wird festgestellt, daß die Turbocodes und deren iterative Decodierung eine wirksame Maßnahme gegen Paketfehler ist.

In ICC '95, Seattle, Washington, Juni 18-22, 1995, "Turbo Codes for BCS Applications", D. Divsalar und F. Pollara, werden Turbocodes vorgeschlagen, um eine Fehlerkorrektur bis nahe an die sogenannte Shannon-Grenze zu erreichen. Dazu sollen verhältnismäßig einfache Komponentencodes und große Interleaver verwendet werden. In dieser Veröffentlichung werden die Turbocodes in einem Codierer mit mehrfachen Codes erzeugt und in einem geeigneten Decodierer decodiert. Die Turbocodes wurden von Berrou et al. 1993 eingeführt (siehe C. Berrou, A. Glavieux und P. Thitimayshima, "Near Shannon limit are correction coding: Turbo codes" Proc. 1993 IEEE International conference on communications, Seiten 1064-1070). Mit dieser Methode kann einerseits eine sehr gute Fehlerkorrektur erreicht werden.

Aus ETT European Transactions on Telecommunications, Vol. 6, No. 5, September-October 1995, "Iterative Correction of Intersymbol Interference: Turbo-Equalization", Catherine Douillard et al. ist die sogenannte Turbo-Entzerrung bekannt, mit der die nachteiligen Effekte der Intersymbolinterferenz bei digitalen Übertragungssystemen behoben werden sollen, die durch Faltungscodes geschützt sind. Der Empfänger führt zwei aufeinanderfolgende Soft-Output-Entscheidungen aus, die von einem Symboldetektor und einem Kanaldecodierer über einen iterativen Prozess durchgeführt werden.

Bei jeder Iteration wird extrinsische Information aus dem Detektor und dem Decoder bei der nächsten Iteration wie bei der Turbodecodierung verwendet. Es wird gezeigt, dass mit der Turbo-Entzerrung Intersymbolinterferenzeffekte bei Mehrweg-Kanälen überwunden werden können.

Die Veröffentlichung "A Novel ARQ Technique using the Turbo Coding Principle", Narayanan et al., IEEE Communications Letters, Bd. 1, Nr. 2, März 1997, Seiten 49-51 beschreibt ein ARQ-III-Verfahren unter Verwendung von punktierten Turbocodes, bei dem nach dem Auftreten von fehlerhaften Datenpaketen die bei der ersten Übertragung punktierten Bits übertragen werden. Der Empfänger setzt anschließend den punktierten Code und die punktierten Bits zusammen und erhält so den unpunktierten Code.

Weitere Anwendungen und Verfahren in Zusammenhang mit Turbo-codes sind aus Nasshan M. et al.: "New Results On The Application Of Antenna Diversity And Turbo-Codes In A JD-CDMA Mobile Radio System", 5th IEEE International Symposium On Personal, Indoor And Mobile Radio Communication (PIMRC'94), And ICCC Regional Meeting On Wireless Computer Networks (WCN), The Hague, The Netherlands, Bd. 2, 18.-23.09.1994, Seiten 524-528, Narayanan K. R. et al.: "Physical Layer Design For Packet Data Over IS-136", 1997 IEEE 47th. Vehicular Technology Conference, Phoenix, AZ, USA, Bd. 2, Nr. 47, 04.-07.05.1997, Seiten 1029-1003 und Jung P. et al.: "Applying Turbo-Codes To The Uplink InA JD-CDMA Mobile Radio System Using Coherent Receiver Antenna Diversity", ITG-Fachbericht 130, Seiten 49-56 bekannt.

Zukünftige Übertragungssysteme, beispielsweise das Europäische UMTS (Universal Mobile Telecommunications System) erfordern die Unterstützung einer Vielzahl von koexistierenden Trägerdiensten mit Trägerdatenraten von bis zu 2 Mbit/s in einer flexiblen Weise, wobei der bestmögliche spektrale Wirkungsgrad angestrebt wird. In dem ACTS (Advanced Communications Technologies and Services) Projekt AC090 FRAMES (Future Radio Wideband Multiple Access Systems) wurde ein MA(Multiple Access)-Schema entwickelt, welches sich FRAMES Multiple Access(FMA) nennt und die Erfordernisse von UMTS erfüllt. Als Übertragungssystem der dritten Generation, welches einen weiten Bereich von Anwendungsgebieten, Trägerdiensten und unterschiedlichen Szenarios umfaßt, muß FMA gegenwärtige und zukünftige Entwicklungen von UMTS Funk-Interface-Standards zu erfüllen. FMA umfaßt zwei Betriebsarten, nämlich WB-TDMA (Wideband Time Division Multiple Access) mit und ohne Spreizung und Kompatibilität mit GSM (Global System for Mobile Communications) und WB-CDMA (Wideband Code Division Multiple Access). Obwohl hier im wesentlichen ein System nach FMA betrachtet wird, können auch andere Übertragungssysteme mit Vielfachzugriffsverfahren, beispielsweise FDMA (Frequenzy Division Multiple Access) oder MC-CDMA (Multicarier-CDMA) oder Kombinationen der erwähnten Übertragungssysteme einbezogen werden.

Im Hinblick auf die hohe Leistungsfähigkeit der Turbocodes ist es wünschenswert, diese bei digitalen Übertragungssystemen einzusetzen. Die vielfältigen Erfordernisse, beispielsweise bei FMA machen es jedoch erforderlich, beim Einsatz derartiger Turbocodes darauf zu achten, daß die Datenübertragung unter voller Ausnutzung der Möglichkeiten der Turbo-Codes erfolgt.

Der Erfindung liegt die Aufgabe zugrunde, ein Verfahren zur Paketübertragung mit einem ARQ-Protokoll auf Übertragungskanälen in einem digitalen Übertragungssystem, bei dem zur Kanalcodierung eine Turbo-Codierung eingesetzt wird, bereitzustellen, bei dem durch einen neuen Turbo-Code und eine darauf abgestimmte Punktierung die Kanalbelastung durch ARQ möglichst gering gehalten werden kann.

Erfindungsgemäß ist dazu das eingangs erwähnte Verfahren durch die Merkmale des Anspruchs 1 gekennzeichnet.

Beim Einsatz des RCPTC's kann die Codierungsrate durch geeignete Punktierung der systematischen oder nicht-systematischen Information am Ausgang des Turbo-Codierers eingestellt werden. Eine Erhöhung der Codierungsrate, das heißt, daß mehr Information auspunktiert wird, verschlechtert dabei bei gegebener Kanalqualität das Ergebnis der Decodierung. Dies bedeutet, daß sich die Bitfehlerrate BER erhöht. Der Einsatz des RCPTC's zur Kanalcodierung ermöglicht es, in paketvermittelten Diensten bei Auslösung eines ARQ nicht das gesamte Paket erneut zu übertragen. Erfolgt die erste Übermittlung des Pakets mit einer hohen Codierungsrate, also einem geringen Fehlerschutz, und wird das Paket als fehlerhaft erkannt, so wird eine ARQ ausgelöst. Sodann wird nicht das gesamte Paket erneut übertragen, sondern nur die bei der ersten Übertragung auspunktierte Information oder ein Teil dieser auspunktierten Information. Die Codierungsrate wird somit kompatibel an den Kanal angepaßt, wodurch insgesamt weniger Daten über den Kanal übertragen werden müssen. Der Vorteil dieses Verfahrens liegt daher in der Verringerung der Gesamtlast auf dem Kanal.

Unter dem Begriff Dienstqualität wird hier folgendes verstanden. Für verschiedene Dienste gelten bestimmte QoS-Kriterien (QoS = Quality of Service = Dienstqualität), und die Definitionen der QoS-Kriterien für verschiedene Trägerdienste sind im Rahmen von FRAMES ausgearbeitet worden. Ein wichtiger Bestandteil eines QoS-Kriteriums ist die Trägerdatenrate R. Das QoS-Kriterium umfaßt auch eine maximal zulässige Fehlerrate $P_b^G$ oder eine Paketverlustrate $P_l^G$ in Kombination mit einer maximalen Ausfallwahrscheinlichkeit $P_{out}^G$. Im Falle von leitungsvermittelten Diensten darf die Wahrscheinlichkeit $Pr\{P_b > P_b^G\}$, daß die augenblickliche Bitfehlerrate $P_b$ die $P_b^G$ übersteigt, nicht größer sein als $P_{out}^G$, das heißt

$$Pr\{P_b > P_b^G\} < P_{out}^G.$$

Bei Sprachübertragung ist $P_b^G$ gleich $10^{-3}$ und $P_{out}^G$ gleich 0,05. Bei Paketdiensten gilt eine ähnliche Bedingung für die augenblickliche Paketverlustrate $P_l$:

$$Pr\{P_l > P_l^G\} < P_{out}^G.$$

Außer den Kriterien bezüglich Pr gibt es noch weitere Bedingungen im Rahmen des QoS-Kriteriums. Hier werden jedoch hauptsächlich die QoS-Parameter $P_b^G$, $P_l^G$ und $P_{out}^G$ betrachtet, die unmittelbar mit der Wahl des Fehlerkorrekturcodes (ECC) zu tun haben. Bei ECC bestimmen das Vielfachzugriffsverfahren, die Modulation und die Paketparameter im wesentlichen die Codierungsrate $R_c$. Mit anderen Worten hat die Codierungsrate $R_c$ einen unmittelbaren Zusammenhang mit der Frage, ob ein QoS-Kriterium für einen bestimmten Dienst erfüllt wird oder nicht.

Bei einem Verfahren, bei dem empfängerseitig ein Soft-Input/Soft-Output- Symbol oder -Sequenzschätzer verwendet wird, ist es vorteilhaft, wenn die Dienstqualität aus den Varianzen $\sigma^2$ der Soft-Decision-Ausgangssignale des Turbo-Decodierers bestimmt wird, wobei vorteilhafterweise aus den Varianzen $\sigma^2$ die Bitfehlerrate als Maß für die Dienstqualität berechnet wird.

Bei einem Verfahren, bei dem empfängerseitig ein MAP-Symbolschätzer oder ein MAP-Sequenzschätzer verwendet wird, ist es vorteilhaft, wenn die Dienstqualität aus den Varianzen $\sigma^2_{LLR}$ der Soft-Decision-Ausgangssignale des Turbo-Decodierers bestimmt wird.

Bei einem Verfahren, bei dem empfängerseitig ein Viterbi-Algorithmus zur Seqenzschätzung verwendet wird, ist es vorteilhaft, wenn die Dienstqualität aus den Varianzen $\sigma^2_{VIT}$ der Soft-Decision-Ausgangssignale des Turbo-Decodierers bestimmt wird.

Bei einem Verfahren, bei dem empfängerseitig ein Viterbi-Algorithmus zur Seqenzschätzung verwendet wird, ist es vorteilhaft,wenn die Dienstqualität aus den Varianzen $\sigma^2_{VIT}$ der Soft-Decision-Ausgangssignale des Turbo-Decodierers bestimmt wird.

Da das erfindungsgemäße Verfahren sowohl bei MAP-Schätzern als auch bei einer Schätzung durch einen Viterbi-Algorithmus einsetzbar ist, gibt es praktisch keine Einschränkung bezüglich der wichtigsten Verfahren zur Sequenz- und Symbolschätzung. Dies gilt, obwohl in der folgenden speziellen Beschreibung diese Aussage nur im Zusammenhang mit einem MAP-Symbolschätzer belegt wird.

Nach einer vorteilhaften Ausgestaltung ist das erfindungsgemäße Verfahren dadurch gekennzeichnet, daß zur Punktierung die sogenannte Berrou's Punktierung eingesetzt wird, bei der nur die nicht-systematische Information punktiert wird. Diese Art der Punktierung ist bei geringeren Werten des Signal/Rausch-Verhältnisses vorteilhaft.

Nach einer vorteilhaften Ausgestaltung ist das erfindungsgemäße Verfahren dadurch gekennzeichnet, daß zur Punktierung die sogenannte UKL-Punktierung eingesetzt wird, bei der sowohl die systematische als auch die nicht-systematische Information punktiert wird. Diese Art der Punktierung ist vorteilhaft bei höheren Signal/Rausch-Verhältnissen und daher bei Bitfehlerraten von < $10^{-4}$.

Nach einer vorteilhaften Ausgestaltung ist das erfindungsgemäße Verfahren dadurch gekennzeichnet, daß bei der erneuten Sendung nur die Bits gesendet werden, die bei der nächst niedrigeren Codierungsrate zusätzlich zur Verfügung stehen, da sie nicht punktiert werden. Dadurch wird nur die minimal erforderliche Information übertragen, um das Ziel einer angemessenen Übertragungsqualität zu erreichen.

Nach einer vorteilhaften Ausgestaltung ist das erfindungsgemäße Verfahren dadurch gekennzeichnet, daß das Verfahren wiederholt wird, bis eine fehlerfreie Decodierung des Pakets erfolgt ist oder die gesamte codierte Information eines Pakets übertragen ist. Damit wird auf jeden Fall das gesamte Potential der Codierung ausgeschöpft, um die Fehler in einem Paket zu korrigieren.

Ausführungsbeispiele der Erfindung werden nun anhand der beiliegenden Zeichnungen beschrieben. Es zeigen:

Figur 1    ein Blockdiagramm eines Turbo-Codierers;

Figur 2    ein Blockdiagramm eines RSC-Codierers, wie er in einem Turbo-Codierer nach Figur 1 verwendet wird;

Figur 3    ein Blockdiagramm eines Turbo-Decodierers;

Figur 4    eine graphische Darstellung zur Leistungsfähigkeit eines RCPTC's bei einem AWGN-Kanal in Abhängigkeit von der Zahl der Iterationen bei der Turbo-Decodierung;

Figur 5    eine graphische Darstellung der Leistungsfähigkeit eines RCPTC's bei einem Rayleigh-Kanal bei verschiedener Anzahl von Iterationen bei der Turbo-Decodierung;

Figur 6    eine graphische Darstellung der Leistungsfähigkeit eines RCPTC's bei einem AWGN-Kanal in Abhängigkeit von unterschiedlichen Codierungsraten;

Figur 7    eine graphische Darstellung der Leistungsfähigkeit eines RCPTC's bei einem Rayleigh-Kanal in Abhängigkeit von verschiedenen Codierungsraten;

Figur 8    eine graphische Darstellung der Leistungsfähigkeit eines RCPTC's bei einem AWGN-Kanal für verschiedene Codierungsraten;

Figur 9    eine graphische Darstellung der Leistungsfähigkeit eines RCPTC's bei einem Rayleigh-Kanal bei unterschiedlichen Codierungsraten;

Figur 10    eine graphische Darstellung der Beziehung zwischen der Bitfehlerrate BER und der Varianz $\sigma^2_{LLR}$ am Ausgang des zweiten Decodierers; und

Figur 11    eine graphische Darstellung der Varianz $\sigma^2_{LLR}$ im Verhältnis zum Signal/Rausch-Verhältnis bei fehlerhaft beziehungsweise korrekt decodierten Paketen.

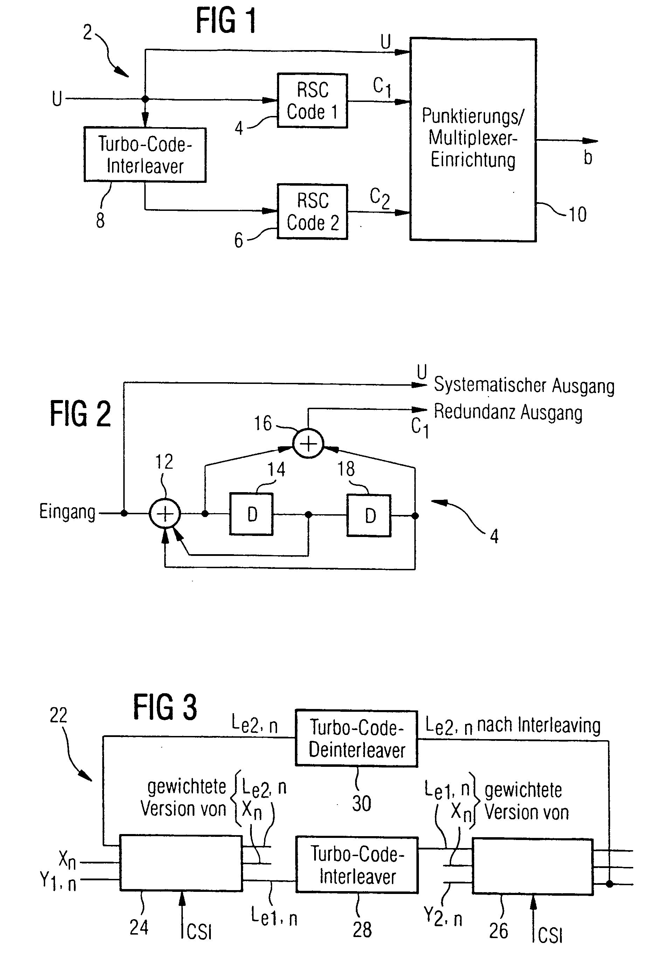

Im Hinblick auf einen ökonomischen Einsatz der Hardware sollte die ECC-Schaltung möglichst universell einsetzbar sein, während die ECC-Konfiguration durch eine Software-Steuerung eine hohe Flexibilität gestatten sollte. Der hier verwendete RCPTC ermöglicht dies, weil er die erforderliche Flexibilität aufweist. Der RCPTC kann mit dem in Figur 1 gezeigten Turbo-Codierer 2 erzeugt werden. Der Turbo-Codierer 2 weist $N_e$ = 2 binäre, rekursive, systematische Faltungscodierer 4, 6 (RSC) mit einer kleinen Constraint-Länge, beispielsweise zwischen 3 und 5, auf, die unter Verwendung eines Turbo-Interleavers 8 parallel geschaltet sind. Die Eingangssequenz u wird dem Codierer 4 (RSC, Code 1) und über den Turbo-Code-Interleaver 8 an den Codierer 6 (RSC, Code 2) sowie einer Punktierungs/Multiplexer-Einrichtung 10 zugeführt. Die Punktierungs/Multiplexer-Einrichtung erhält einen weiteren Eingang C1 von dem Codierer 4 und einen weiteren Eingang C2 von dem Codierer 6. Der Ausgang der Punktierungs/Multiplexer-Einrichtung 10 ist die Ausgangssequenz b.

Bei dem Turbo-Codierer 2 ist die minimale Coderate $R_c$, min gleich $1/(N_{e+1})$ = 1/3. Die minimale Codierungsrate $R_c$, min könnte weiter reduziert werden, indem zusätzliche RSC-Codierer eingesetzt werden.

Die binäre Eingangssequenz u, die eine endliche Zeitdauer hat, wird in den Codierer 4 eingegeben und ergibt an dessen Ausgang die Redundanzsequenz $C_1$ mit derselben endlichen Dauer wie u. Die Sequenz $u_I$, die die Sequenz u nach dem Interleaving darstellt, wird in den Codierer 6 gegeben. Die Codierung in dem Codierer 6 ergibt die Redundanzsequenz $C_2$. Die Redundanzsequenzen $C_1$ und $C_2$ und die Sequenz u werden punktiert und gemultiplext, um die Ausgangssequenz b zu bilden. Der Turbocodierer ist ein systematischer Codierer, wobei u die Basis der in b enthaltenen, systematischen Information ist.

Ein RSC-Codierer, wie er für die Codierer 4 und 6 verwendet werden kann, ist in Figur 2 am Beispiel des Codierers 4 dargestellt. An einem Eingang des Codierers 4 steht die Sequenz u als systematische Information an. Die Sequenz u gelangt über ein Additionsglied 12 zu einer Verzögerungsstufe 14 und einem weiteren Additionsglied 16. Die Ausgangssignale der Verzögerungsstufe 14 gelangt an eine zweite Verzögungsstufe 18 und an das Additionsglied 12. Die Ausganssignale der zweiten Verzögerungsstufe 18 gelangen an die Additionsstufe 12 und die Additionsstufe 16. Der Ausgang der Additionsstufe ist dann die Reduntanzsequenz $c_1$.

Bei der Wahl dieses Codierers spielen die Hardwarekosten eine Rolle, die so niedrig wie möglich gehalten werden sollten. Aus diesem Grund sind die beiden RSC-Codierer zur Verwendung im Rahmen von FRAMES identisch und haben eine Constraint-Länge von 3. Obwohl diese RSC-Codierer nur vier Zustände haben, zeigen sie eine gute Leistungsfähigkeit bei niedrigen Werten des Signal/Rausch-Verhältnisses $E_b/N_0$. Daher ist die Leistungsfähigkeit desRCPTC's mit diesen Codierern bei niedrigen Signal-Rausch-Verhältnissen vorteilhaft.

Die Ausgangssequenz b des Turbo-Codierers 2 gelangt über den Übertragungskanal und einen Demodulator zu dem Turbo-Decodierer 22 (Figur 3), der einen RSC-Codierer 24 und einen zweiten RSC-Decodierer 26 aufweist. Zwischen einem Ausgang des Decodierers 24 und einem Eingang des Decodierers 26 ist ein Turbo-Code-Interleaver 28 vorgesehen. Zwischen einem Ausgang des Decodierers 26 und einem Eingang des Decodierers 24 ist ein Turbo-Code-Interleaver 30 vorgesehen. Die Decoder 24, 26 sind Soft-Input/Soft-Output-Decoder.

Der Demodulator (nicht gezeigt) liefert Schätzwerte $x_n$ der systematischen Information $u_n$, die in u enthalten sind, sowie Schätzwerte $y_{1,n}$ und $y_{2,n}$ der übertragenen Redundanzbits, die von den Codierern 4 beziehungsweise 6 erzeugt worden sind. Die beiden Decodierer 24, 26 benötigen eine Kanalzustandsinformation (CSI = Channel State Information), die aus den augenblicklichen Signalamplituden und der Rauschvarianz besteht. Jeder der Decodierer 24, 26 verarbeitet die systematische Information, die Redundanz und a-priori-Information $L_{e1,n}$ und $L_{e2,n}$ unter Verarbeitung der CSI, wodurch die extrinsische Information $L_{e2,n}$ und $L_{e1,n}$ erzeugt wird, die dann als a-priory-Wissen bei dem nachfolgenden Decodierer verwendet wird. Die Decodierung ist iterativ, und das Ergebnis der Decodierung wird mit jeder Iteration verbessert. Das Maß der Verbesserung nimmt jedoch allmählich mit der weiteren Iteration ab. Nach einer gewissen Anzahl von Iterationen wird das Ausgangssignal des Turbo-Decodierers 22 in einen Detektor (nicht gezeigt) zugeführt, wie es bei derartigen Übertragungssystemen üblich ist.

Um den Einsatz desRCPTC's auf die vorhandenen Diensterfordernisse anzupassen, könnte man daran denken, die RSC-Codierer anzupassen, was jedoch zu einer unerwünschten Mehrbelastung im Bezug auf die Hardwarekosten führen würde. Die Anpassung der Interleavergröße auf die speziellen Dienste ist an sich bekannt und stellt auch bei der Verwendung einesRCPTC's wegen dessen Flexibilität ein Problem dar.

Desweiteren kann die Zahl der Iterationen bei der Decodierung entsprechend dem QoS-Kriterium eingestellt werden unter Berücksichtigung der gesamten Codierungskomplexität. Zwei Möglichkeiten, um diese Eigenschaft des Turbocodes auszunutzen, sind an dem Empfänger gegeben. Für ein vorgegebenes QoS-Kriterium kann die Zahl der Iterationen mit ansteigendem Signal/Rausch-Verhältnis $E_b/N_0$ erhöht werden. Dies ist besonders vorteilhaft bei Fading-Kanälen, beispielsweise bei Übertragungskanälen. Andererseits kann die Zahl der Iterationen auch mit einem sich zeitlich ändernden QoS-Kriterium variiert werden. Die Einstellbarkeit der Zahl der Decodierungs-Iterationen ist nur bei der Verwendung von Turbo-Codes, insbesondere eines RCPTC's gegeben.

Eine weitere Möglichkeit die Leistungsfähigkeit in einem System mit einem RCPTC zu verbessern, besteht darin, die Punktierung einzustellen, so daß ein RCPTC mit variierenden Coderaten $R_{C,min} <= R_C <= R_{C,max}$ bereitgestellt werden können, wodurch die Codierungseigenschaften bei unveränderten Turbo-code-Interleavern und RSC-Codierern geändert werden können.

Für die Punktierung stehen prinzipiell die Sequenzen u, $c_1$ und $c_2$ zu Verfügung. Wenn zwei der Sequenzen voll durch Punktierung unterdrückt werden, wird die maximale Coderate $R_{C,max} = 1$ angenommen. In diesem Fall hängen die Codierungseigenschaften davon ab, welche der Sequenzen punktiert werden. Wenn beispielsweise die Redundanzsequenzen $c_1$ und $c_2$ vollständig punktiert werden, wobei nur die Sequenz u unverändert durchgelassen wird, ist eine ECC nicht erhältlich, und Zeit Diversity-Gewinne sind an den Empfängern bei Fading-Kanälen nicht erreichbar. In diesem Fall reduziert sich der Turbo-Decodierer auf einen einfachen Schwellenwertdetektor.

Wenn eine der Redundanzsequenzen $C_1$ oder $C_2$ voll durch die Punktierung unterdrückt wird, wobei nur die zweite Redundanzsequenz zusammen mit der Sequenz u hindurchtreten kann, wird der Turbo-Codierer zu einem herkömmlichen RSC-Codierer. Der Turbo-Decodierer reduziert sich zu einem RSC-Decodierer, der zur Durchführung einer halben Iteration realisiert ist. Ein a-priori-Wissen basierend auf einer extrinsischen Information ist in diesem Fall nicht vorhanden. Die Codierungsrate $R_c$ kann zwischen ½ und 1 je nach dem QoS-Kriterium variiert werden. Da $N_e = 2$ gilt, können die RSC-Codierer auf zwei unterschiedlichen Codes basieren, und das QoS-Kriterium und die Codierungskomplexität können variiert werden, indem eine bestimmte Redundanzsequenz $C_1$ oder $C_2$ ohne Änderung der Codierungsrate $R_c$ unterdrückt wird.

Die oben erwähnten Möglichkeiten verhindern jedoch einen Turbo-Code-Betrieb, der nur zur Verfügung steht, wenn Bits von beiden Redundanzsequenzen $C_1$ und $C_2$ übertragen werden und gilt:

$$u_n \# u_{1,n}$$

wobei $u_n$ und $u_{1,n}$ in u beziehungsweise $u_1$ enthalten sind. In diesem Fall gilt:

$$R_{c,min} \le R_c < 1.$$

Die minimale Codierungsrate $R_{c,min} = 1/(N_e + 1)$ wird realisiert, wenn keine Punktierung durchgeführt wird. In diesem Fall kann entweder die herkömmliche RSC-Decodierung oder die Turbo-Decodierung realisiert werden, je nach dem QoS-Kriterium und Übertragungskanalzustand, wobei beide Faktoren bei Übertragungsanwendungen zeitlich variieren.

Bei echtem Turbo-Codebetrieb sind folgende Varianten möglich. Die Sequenz u wird nicht punktiert, die Redundanzsequenzen $c_1$ und $c_2$ werden teilweise punktiert. In diesem Fall ist ein Betrieb als RSC-Code oder als Turbo-Code möglich, die Zahl der Decodierungs-Iterationen ist einstellbar und die Codierungsrate kann zwischen 1/3 und 1 liegen. Diese Art der Punktierung wird Berrou's-Punktierung genannt.

Eine alternative Möglichkeit besteht darin, daß die Sequenz u und die Redundanzsequenzen $c_1$ und $c_2$ teilweise punktiert werden. In diesem Fall ist ein Betrieb mit RSC-Code nicht möglich, sondern nur mit einem Turbo-Code. Die Zahl der Decodierungs-Iterationen ist einstellbar, und die Codierungsrate kann zwischen 1/3 und 1 liegen. Diese Art der Punktierung wird UKL-Punktierung (UKL = University Kaiserslautern) genannt. Schließlich kann noch der Fall betrachtet werden, daß keine Punktierung stattfindet. In diesem Fall ist der Betrieb mit einem RSC-Code und einem Turbo-Code möglich. Die Zahl der Decodierungs-Iterationen ist einstellbar und die Codierungsrate liegt bei 1/3.

Das vorteilhafte Merkmal bei RSPTC liegt in der Möglichkeit, die Codierungsrate $R_c$ adaptiv zu ändern, wobei bei einem ARQ die erfordeliche Information übertragen werden kann, ohne das gesamte, codierte Paket übertragen zu müssen. Die Übertragung eines zusätzlichen Teiles der Information, der die Differenz in der Codierungsrate ausgleicht, ist ausreichend.

Nachdem die Möglichkeiten der Anpassung der Codierung, im Fall von RCPTC beschrieben wurden, werden nun die Auswirkungen der Anpassungsmöglichkeiten auf die Leistungsfähigkeit des Systems bei Verwendung von RCPCT anhand von Simulationen beschrieben.

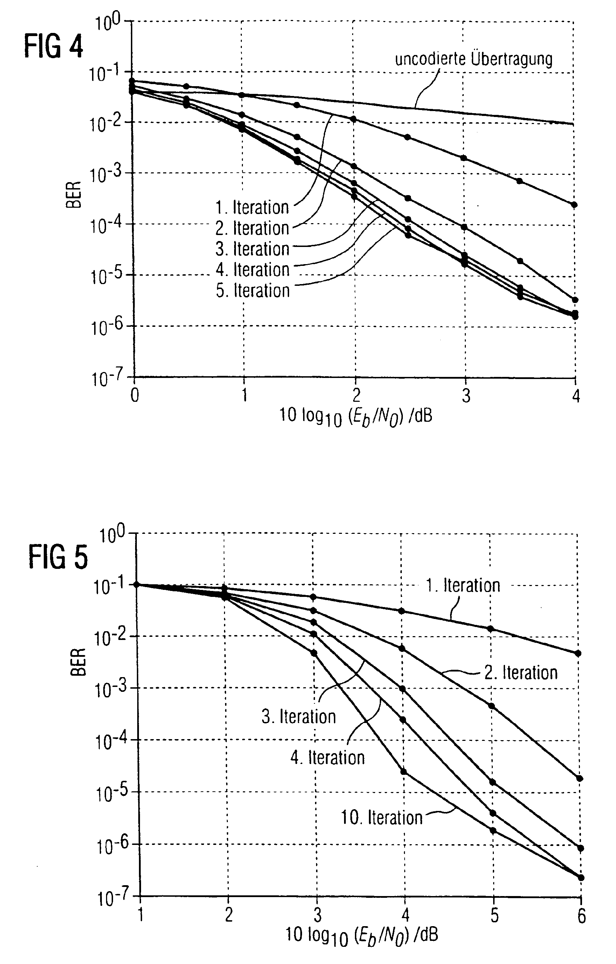

Figur 4 zeigt die Leistungsfähigkeit des RCPTC in einer graphischen Darstellung in der die Bitfehlerrate BER gegen das Signal/Rausch-Verhältnis $E_b/N_0$ für eine Sprachübertragung über einen AWGN-Kanal dargestellt ist. Die Paketgröße war 150 bit, und die Codierungsrate etwa = 1/3. Die Trägerdatenrate für die Sprachübertragung betrug 8 = kbit/s. Die uncodierte Übertragung wird als Bezugslinie gezeigt. Der Parameter dieser Simulationen ist die Zahl der Decodierungs-Iterationen, die zwischen 1 und 5 variiert. Nach der ersten Decodierungs-Iteration ist das minimale Signal/Rausch-Verhältnis, das erforderlich ist, um eine Bitfehlerrate von < $10^{-3}$ zu erreichen, etwa gleich 3,5 dB. Nach der zweiten Decodierungs-Iteration ist etwa 1,3 dB weniger erforderlich. Die nächste Decodierungs-Iteration ermöglicht einen weiteren Gewinn von 0,2 dB. Die nächsten Iteration ermöglichen Gewinne von weniger als 0,1 dB. Nach fünf Iterationen ist das minimale Signal/Rausch-Verhältnis, das für eine Bitfehlerrate von weniger als $10^{-3}$ erforderlich ist, etwa gleich 1,8 dB. Es ist demnach ersichtlich, daß die Leistungsverbesserung mit zunehmender Iterationen weniger wird. Im Vergleich erfordert ein herkömmlicher NSC-Code mit einer Constraint-Länge von 9 etwa 1,9 dB, um dieselbe Bitfehlerrate von < $10^{-3}$ zu erreichen. Der RCPTC ist daher etwas leistungsfähiger als herkömmliche Codes selbst bei so kleinen Paketgrößen wie 150 bit.

Figur 5 zeigt die Leistungsfähigkeit des RCPTC in einer graphischen Darstellung, in der die Bitfehlerraten BER gegen das Signal/Rausch-Verhältnis $E_B/N_0$ für Schmalband-ISDN bei einer Trägerdatenrate von 144 kbit/S, einer Paketgröße von 672 bit, einer Coderate von etwa ½ und einem voll einem Interleaving unterzogenen Rayleigh-Fading-Kanal gezeigt ist. Der Simulationsparameter ist wiederum die Zahl der Decodierungs-Iterationen. Nach vier Decodierungs-Iterationen erfordert eine Bitfehlerrate von weniger als $10^{-3}$ ein minimales Signal/Rausch-Verhältnis von 3,8 dB. Nach zehn Iterationen sind nur noch etwa 3,4 dB erforderlich. Ein herkömmlicher NSC-Code mit einer ähnlichen Decodierungskomplexität wie vier Decodierungs-Iterationen hat einen Constraint-Länge von 8 und erfordert ein um 1,1 dB höheres Signal/Rausch-Verhältnis.

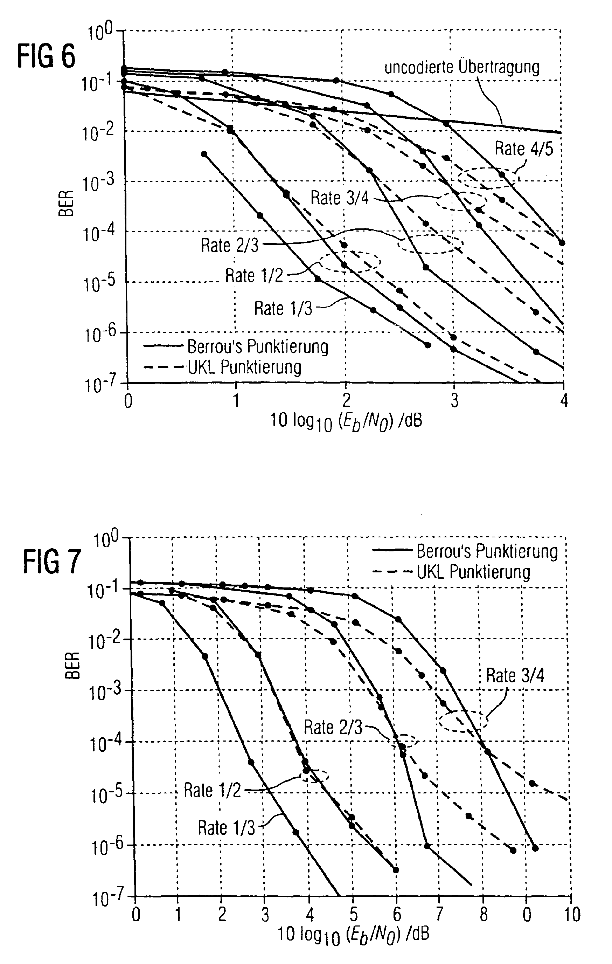

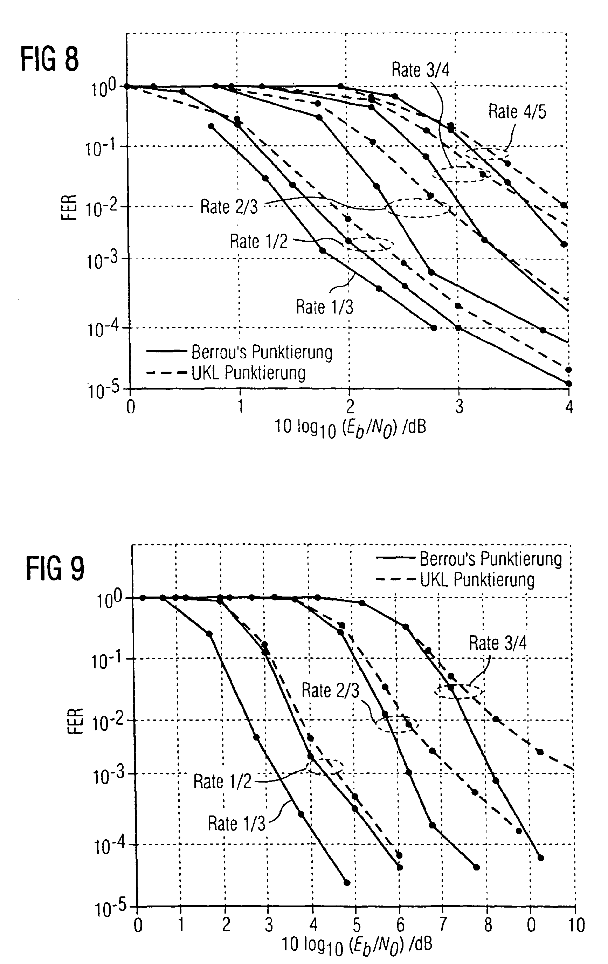

Die Figuren 6 bis 9 zeigen graphische Darstellungen für die Leistungsfähigkeit bei Verwendung von RCPTC, wobei die Bitfehlerrate BER beziehungsweise die Rahmenfehlerrate FER gegen das Signal/Rausch-Verhältnis $E_B/N_0$ aufgetragen ist. Figur 6 zeigt die Bitfehlerrate gegen das Signal/Rausch-Verhältnis bei einer Paketgröße von 672 bit, zehn Decodierungs-Iterationen und einem AWGN-Kanal. Figur 7 zeigt die Bitfehlerrate gegen das Signal/Rausch-Verhältnis bei einer Paketgröße von 672 bit, zehn Decodierungs-Iterationen und einem voll einem Interleaving unterworfenen Rayleigh-Fading-Kanal. Figur 8 zeigt die Rahmenfehlerrate FER gegen das Signal/Rausch-Verhältnis bei einer Paketgröße von 672 bit,zehn Decodierungs-Iterationen und einem AWGN-Kanal. Figur 9 zeigt die Rahmenfehlerrate gegen das Signal/Rausch-Verhältnis bei einer Paketgröße von 672 bit, 10 Decodierungs-Iterationen und einem voll einem Interleaving unterworfenen Rayleigh-Fading-Kanal. In den graphischen Darstellungen der Figuren 6 bis 9 werden zwei unterschiedliche Punktierungsverfahren angewendet, nämlich die Berrou's-Punktierung und die UKL-Punktierung, die oben erwähnt wurden. Es ist ersichtlich, daß die Berrou's-Punktierung eine bessere Leistungsfähigkeit bei geringeren Werten des Signal/Rausch-Verhältnisses hat, während die UKL-Punktierung bei einem hohen Signal/Rausch-Verhältnis und daher bei Bitfehlerraten von < $10^{-4}$ vorteilhaft ist. Die Kreuzungspunkte bewegen sich in Richtung auf niedrigere Bitfehlerraten bei wachsenden Codierungsraten.

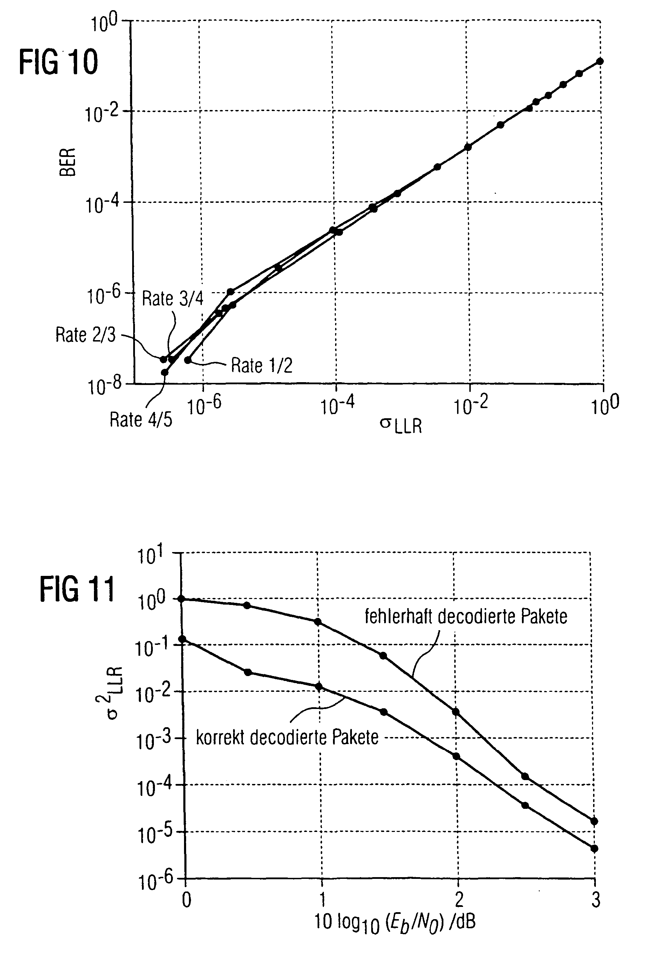

In Figur 10 ist die Bitfehlerrate gegen die Varianz der log-Likelihood-Verhältnisse (LLR = Log-Likelihood Ratio) an dem Ausgang des zweiten Decodierers gezeigt, wobei ein RCPTC, eine Paketgröße von 372 bit, zehn Decodierungs-Iterationen und ein AWGN-Kanal angenommen wird. Aus dieser Figur ist ersichtlich, daß die Codierungsrate keinen Einfluss auf die Beziehung zwischen der Bitfehlerrate und der Varianz $\sigma^2_{LLR}$ hat, weil diese beiden Größen eine ähnliche Abhängigkeit von dem Signal/Rausch-Verhältnis $E_B/N_0$ haben. Daher kann, wenn $\sigma^2_{LLR}$ bekannt ist, eine Abschätzung der Bitfehlerrate leicht durchgeführt werden, deren Ergebnis als Basis für eine Aktion dienen kann, beispielsweise für eine Anpassung der Decodierungs-Iterationszahl oder der Codierungsrate zur Verbesserung der Übertragungsqualität oder, im Falle von ARQ, zur Anforderung einer erneuten Sendung eines fehlerhaft codierten Pakets.

Schließlich zeigt Figur 11 die Varianz $\sigma^2_{LLR}$ des Log-Likelihood-Verhältnisses LLR am Ausgang des zweiten Decodierers im Verhältnis zu dem Signal/Rausch-Verhältnis $E_B/N_0$ bei Verwendung von RCPTC mit einer Paketgröße von 600 bit, einer Coderate von etwa 5/9, zehn Decodierungs-Iterationen und einem AWGN-Kanal. Der RCPTC war für einen 64 kbit/S-Trägerservice ausgelegt. Aus Figur 11 ergibt sich, daß eine ähnliche Überlegung wie im Zusammenhang mit Figur 10 auch für die Abhängigkeit der Varianz $\sigma^2_{LLR}$ von dem Auftreten von Paketfehlern zutrifft. $\sigma^2_{LLR}$ ist bei fehlerhaft decodierten Paketen immer größer als $\sigma^2_{LLR}$ im Falle von korrekt decodierten Paketen. Wenn daher das Signal/Rausch-Verhältnis $E_B/N_0$ und $\sigma^2_{LLR}$ für ein gerade überprüftes Paket bekannt sind, kann eine Soft-Decision-Variable, die mit der Wahrscheinlichkeit eines Paketfehlers in Beziehung steht, leicht erzeugt und zu Steuerungszwecken eingesetzt werden.

Obwohl sich die vorliegende Beschreibung hauptsächlich auf die Anwendung der Erfindung auf den digitalen Mobilfunk bezieht, ist die Erfindung nicht darauf beschränkt sondern kann allgemein bei digitalen Übertragungssystemen, beispielsweise bei leistungsgebundenen Systemen, optischen Übertragunssystemen (Infrarot- und Laser-Übertragunssysteme), Satellitenfunksystemen, Deep-Space-Übertragunssystemen, Richtfunk-Übertragunssystemen und Rundfunk-Übertragunssystemen (Digitales Radio oder TV), mit den genannten Vorteilen eingesetzt werden.

**Patentansprüche**

1. Verfahren zur Paketübertragung mit einem ARQ (Automatic Repeat ReQuest)-Protokoll auf Übertragungskanälen in einem digitalen Übertragungssystem, bei dem zur Kanalcodierung senderseitig in einem Turbo-Codierer (2) eine Turbo-Codierung und empfängerseitig in einem Turbo-Decodierer (22) eine Turbo-Decodierung durchgeführt wird, wobei ein Rückkanal vorgesehen ist, über den der Empfänger fehlerhaft codierte Pakete erneut anfordern kann, wobei bei einer erneuten Übertragung eines fehlerhaft codierten Paketes wenigstens ein Teil der durch die Punktierung des Turbocodes bei der vorhergehenden Übertragund unterdrückten Information gesendet wird und die zusätzlich übertragene Information empfängerseitig in die bereits vorhandene Information eingefügt und diese vervollständigte Information erneut decodiert wird **dadurch gekennzeichnet, daß**

   - ein punktierter Turbocode mit variabler Codierungsrate (RCPTC) verwendet wird, und daß
   - die Codierungsrate des Turbo-Codierers (2) in Abhängigkeit von der Dienstqualität (QoS) des Übertragungskanals gewählt wird.

2. Verfahren nach Anspruch 1, **dadurch gekennzeichnet, daß** eine erneute Übertragung fehlerhaft codierter Pakete (ARQ) in Abhängigkeit von der Dienstqualität (QoS) des Übertragungskanals ausgelöst wird.

3. Verfahren nach Anspruch 2, **dadurch gekennzeichnet, daß**

   - die Dienstqualität (QoS) des Übertragungskanals bestimmt wird, daß
   - die Dienstqualität (QoS) des Übertragungskanals mit einem Sollwert verglichen wird, und daß
   - eine erneute Übertragung fehlerhaft codierter Pakete (ARQ) bei Nichterreichen des Sollwerts ausgelöst wird.

4. Verfahren nach Anspruch 3, wobei empfängerseitig ein Soft-Input/Soft-Output-Symbol- oder Sequenzschätzer verwendet wird, **dadurch gekennzeichnet, daß** die Dienstqualität (QoS) aus den Varianzen ($\sigma_{LLR}^2$) der Soft-Decision-Ausgangssignale des Turbo-Decodierers bestimmt wird.

5. Verfahren nach Anspruch 4, **dadurch gekennzeichnet, daß** aus den Varianzen ($\sigma_{LLR}^2$) die Bitfehlerrate (BER) als Maß für die Dienstqualität (QoS) berechnet wird.

6. Verfahren nach den Ansprüchen 3 bis 5, **dadurch gekennzeichnet, daß** die Anzahl der erneut übertragenen Datenpakete in Abhängigkeit von der Dienstqualität (QoS) des Übertragungskanals gewählt wird.

7. Verfahren nach Anspruch 6, **dadurch gekennzeichnet, daß** die Anzahl der erneut übertragenen Datenpakete derart gewählt wird, daß nach der erneuten Übertragung die Dienstqualität (QoS) des Übertragungskanals den Sollwert erreicht.

**8.** Verfahren nach Anspruch 3, wobei empfängerseitig ein MAP-Symbolschätzer oder ein MAP-Sequenzschätzer verwendet wird, **dadurch gekennzeichnet,**
**daß** die Dienstqualität (QoS) aus den Varianzen ($\sigma^2_{LLR}$) der Soft-Decision-Ausgangssignale des Turbo-Decodierers bestimmt wird.

**9.** Verfahren nach Anspruch 3, wobei empfängerseitig ein Viterbi-Algorithmus zur Sequenzschätzung verwendet wird,
**dadurch gekennzeichnet,**
**daß** die Dienstqualität (QoS) aus den Varianzen ($\sigma^2_{VIT}$) der Soft-Decision-Ausgangssignale des Turbo-Decodierers bestimmt wird.

**10.** Verfahren nach einem der vorhergehenden Ansprüche,
**dadurch gekennzeichnet,**
**daß** zur Punktierung eine sogenannte Berrou's Punktierung eingesetzt wird, bei der nur die nicht-systematische Information punktiert wird.

**11.** Verfahren nach einem der Ansprüche 1 bis 9,
**dadurch gekennzeichnet,**
**daß** zur Punktierung die sogenannte UKL-Punktierung eingesetzt wird, bei der sowohl eine systematische als auch die nicht-systematische Information punktiert wird.

**Claims**

**1.** Method for packet transmission using an ARQ (Automatic Repeat ReQuest) protocol on transmission channels in a digital transmission system, wherein for channel coding purposes turbo coding is performed in a turbo coder (2) at the transmitter end and turbo decoding is performed in a turbo decoder (22) at the receiver end, with a return channel being provided via which the receiver can issue repeat requests for incorrectly coded packets, with at least a part of the information suppressed by the puncturing of the turbo code during the previous transmission being sent when an incorrectly coded packet is retransmitted and the additionally transmitted information being inserted into the already existing information at the receiver end and said completed information being decoded again,
**characterised in that**

- a punctured turbo with a variable coding rate (RCPTC) is used, and that
- the coding rate of the turbo coder (2) is chosen as a function of the quality of service (QoS) of the transmission channel.

**2.** Method according to claim 1, **characterised in that** a retransmission of incorrectly coded packets (ARQ) is initiated as a function of the quality of service (QoS) of the transmission channel.

**3.** Method according to claim 2, **characterised in that**

- the quality of service (QoS) of the transmission channel is determined, that
- the quality of service (QoS) of the transmission channel is compared with a reference value, and that
- a retransmission of incorrectly coded packets (ARQ) is initiated if the reference value is not achieved.

**4.** Method according to claim 3, wherein a soft-input/soft-output symbol or sequence estimator is used at the receiver end,
**characterised in that** the quality of service (QoS) is determined from the variances ($\sigma_{LLR}^2$) of the soft-decision output signals from the turbo decoder.

**5.** Method according to claim 4, **characterised in that** the bit error rate (BER) is calculated from the variances ($\sigma_{LLR}^2$) as a measure for the quality of service (QoS).

**6.** Method according to claims 3 to 5, **characterised in that** the number of retransmitted data packets is chosen as a function of the quality of service (QoS) of the transmission channel.

**7.** Method according to claim 6, **characterised in that** the number of retransmitted data packets is chosen such that after the retransmission the quality of service (QoS) of the transmission channel reaches the reference value.

**8.** Method according to claim 3, wherein a MAP symbol estimator or MAP sequence estimator is used at the receiver end, **characterised in that** the quality of service (QoS) is determined from the variances ($\sigma^2_{LLR}$) of the soft-decision output signals from the turbo decoder.

**9.** Method according to claim 3, wherein a Viterbi algorithm is used for sequence estimation at the receiver end,
**characterised in that** the quality of service (QoS) is determined from the variances ($\sigma^2_{VIT}$) of the soft-decision output signals from the turbo decoder.

**10.** Method according to one of the preceding claims, **characterised in that**

a scheme known as Berrou's puncturing is used for puncturing, wherein only the non-systematic information is punctured.

11. Method according to one of claims 1 to 9, **characterised in that**
a scheme known as UKL puncturing is used for puncturing, wherein both systematic and non-systematic information is punctured.

## Revendications

1. Procédé pour la transmission par paquets avec un protocole ARQ (Automatic Repeat ReQuest) sur des canaux de transmission dans un système de transmission numérique, dans lequel un codage turbo est exécuté côté émetteur dans un codeur turbo (2) pour le codage turbo et un décodage turbo est exécuté côté récepteur dans un décodeur turbo (22), un canal de retour étant prévu, par l'intermédiaire duquel le récepteur peut de nouveau demander des paquets codés de manière erronée, au moins une partie de l'information supprimée en raison de la ponctuation du turbo code lors de la transmission précédente étant émise lors d'une nouvelle transmission d'un paquet codé de manière erronée et l'information transmise en plus étant insérée côté récepteur dans l'information déjà présente et cette information complétée étant de nouveau décodée, **caractérisé en ce qu'**

    - un turbo code ponctué avec taux de codage variable (RCPTC) est utilisé, et en ce que
    - le taux de codage du codeur turbo (2) est sélectionné en fonction de la qualité de service (QoS) du canal de transmission.

2. Procédé selon la revendication 1, **caractérisé en ce qu'**une nouvelle transmission de paquets codés de manière erronée (ARQ) est déclenchée en fonction de la qualité de service (QoS) du canal de transmission.

3. Procédé selon la revendication 2, **caractérisé en ce que**

    - la qualité de service (QoS) du canal de transmission est déterminée, **en ce que**
    - la qualité de service (QoS) du canal de transmission est comparée à une valeur théorique, et **en ce qu'**
    - une nouvelle transmission de paquets codés de manière erronée (ARQ) est déclenchée lorsque la valeur théorique n'est pas atteinte.

4. Procédé selon la revendication 3, un estimateur de symboles soft-input/soft-output ou estimateur séquentiel étant utilisé,
**caractérisé en ce que** la qualité de service (QoS) est déterminée à partir des variances ($\sigma_{LLR}^2$) des signaux de sortie de décision douce du décodeur turbo.

5. Procédé selon la revendication 4, **caractérisé en ce que** le taux d'erreur sur les bits (BER) est calculé à partir des variances ($\sigma_{LLR}^2$) en tant que mesure pour la qualité de service (QoS).

6. Procédé selon l'une quelconque des revendications 3 à 5, **caractérisé en ce que** le nombre de paquets de données de nouveau transmis est sélectionné en fonction de la qualité de service (QoS) du canal de transmission.

7. Procédé selon la revendication 6, **caractérisé en ce que** le nombre de paquets de données de nouveau transmis est sélectionné de manière à ce que la qualité de service (QoS) du canal de transmission atteigne la valeur théorique après la nouvelle transmission.

8. Procédé selon la revendication 3, un estimateur de symboles MAP ou un estimateur séquentiel MAP étant utilisé côté récepteur, **caractérisé en ce que** la qualité de service (QoS) est déterminée à partir des variances ($\sigma^2_{LLR}$) des signaux de sortie soft decision du décodeur turbo.

9. Procédé selon la revendication 3, un algorithme de Viterbi étant utilisé côté récepteur pour l'estimation séquentielle, **caractérisé en ce que** la qualité de service (QoS) est déterminée à partir des variances ($\sigma^2_{VIT}$) des signaux de sortie soft décision du décodeur turbo.

10. Procédé selon l'une quelconque des revendications précédentes, **caractérisé en ce que** pour la ponctuation, une dite ponctuation de Berrou est utilisée, dans laquelle seulement l'information non systématique est ponctuée.

11. Procédé selon l'une quelconque des revendications 1 à 9, **caractérisé en ce que** pour la ponctuation, ladite ponctuation UKL est utilisée, dans laquelle aussi bien une information systématique que l'information non-systématique sont ponctuées.

## FIG 1

U

2

U → (•)

Turbo-Code-Interleaver
8

RSC Code 1    C₁
4

RSC Code 2    C₂
6

Punktierungs/ Multiplexer-Einrichtung

→ b

10

## FIG 2

U Systematischer Ausgang
Redundanz Ausgang
C₁

16

12

14    18

Eingang → (•) → (+) → (•) → D → (•) → D → (•)

4

## FIG 3

22

Le2, n    Turbo-Code-Deinterleaver    Le2, n nach Interleaving

gewichtete { Le2, n
Version von { Xn }

30

Le1, n } gewichtete
Xn } Version von

Xn
Y1, n

24    CSI

Le1, n

Turbo-Code-Interleaver

28

Y2, n    26    CSI

FIG 4

uncodierte Übertragung

1. Iteration
2. Iteration
3. Iteration
4. Iteration
5. Iteration

BER

$10\ log_{10}\ (E_b/N_0)\ /dB$

FIG 5

1. Iteration

2. Iteration

3. Iteration

4. Iteration

10. Iteration

BER

$10\ log_{10}\ (E_b/N_0)\ /dB$

FIG 6

FIG 7

**FIG 8**

**FIG 9**

**FIG 10**

**FIG 11**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **P. JUNG.** Comparison of Turbo-Code Decoders Applied to Short Frame Transmission Systems. *IEEE Journal on Selected Areas in Communications,* 1996, vol. 14, 530-537
- **D. DIVSALAR ; F. POLLARA.** Turbo Codes for BCS Applications. *In ICC '95,* 18. Juni 1995
- **C. BERROU ; A. GLAVIEUX ; P. THITIMAYSHIMA.** Near Shannon limit are correction coding: Turbo codes. *Proc. 1993 IEEE International conference on communications,* 1993, 1064-1070
- **CATHERINE DOUILLARD.** Iterative Correction of Intersymbol Interference: Turbo-Equalization. *ETT European Transactions on Telecommunications,* September 1995, vol. 6 (5
- **NARAYANAN et al.** A Novel ARQ Technique using the Turbo Coding Principle. *IEEE Communications Letters,* Marz 1997, vol. 1 (2), 49-51
- **NASSHAN M. et al.** New Results On The Application Of Antenna Diversity And Turbo-Codes In A JD-CDMA Mobile Radio System. *5th IEEE International Symposium On Personal, Indoor And Mobile Radio Communication (PIMRC'94), And ICCC Regional Meeting On Wireless Computer Networks (WCN,* 18. September 1994, vol. 2, 524-528
- **NARAYANAN K. R. et al.** Physical Layer Design For Packet Data Over IS-136. *IEEE 47th. Vehicular Technology Conference,* 04. Mai 1997, vol. 2 (47), 1029-1003
- **JUNG P. et al.** Applying Turbo-Codes To The Uplink InA JD-CDMA Mobile Radio System Using Coherent Receiver Antenna Diversity. *ITG-Fachbericht,* vol. 130, 49-56